Europäisches Patentamt

European Patent Office

Office européen des brevets

(19)

(11)   EP 0 480 494 B1

(12)   EUROPEAN PATENT SPECIFICATION

(45) Date of publication and mention
of the grant of the patent:
**26.11.1997   Bulletin 1997/48**

(51) Int Cl.$^6$: **H03D 9/06**, H03B 5/18

(21) Application number: **91202440.3**

(22) Date of filing: **20.09.1991**

(54) **Self-oscillating microwave frequency converter comprising a dielectric resonator**

Selbsttätig oszillierender Mikrowellen- Frequenzumsetzer mit einem Dielektrischen Resonator

Convertisseur de fréquence à micro-ondes autooscillant comprenant un résonateur diélectrique

(84) Designated Contracting States:
**DE ES FR GB GR IT SE**

(30) Priority: **09.10.1990  IT   2168490**

(43) Date of publication of application:
**15.04.1992   Bulletin 1992/16**

(73) Proprietor: **Italtel s.p.a.**
**20149 Milano (IT)**

(72) Inventors:
• **Buoli, Carlo**
**I-41030 Mirandola, Modena (IT)**
• **Cervi, Luigi**
**I-26010 Olmeneta, Cremona (IT)**
• **Turillo, Tommaso**
**I-20131 Milano (IT)**

(56) References cited:
**EP-A- 0 057 480**       **DE-A- 2 816 586**
**US-A- 4 658 440**

• **ELECTRONICS LETTERS. vol. 17, no. 17, 20
August 1981, ENAGE GB pages 617 - 618; C.
TSIRONIS: '12 GHZ RECEIVER WITH
SELF-OSCILLATING DUAL-GATE MESFET
MIXER'**
• **PATENT ABSTRACTS OF JAPAN vol. 11, no. 204
(E-520)(2651) 2 July 1987 & JP-A-62 026 909
( FUJITSU LTD ) 4 February 1987**
• **PATENT ABSTRACTS OF JAPAN vol. 14, no. 476
(E-991)17 October 1990 & JP-A-02 194 706
( MITSUBISHI ELECTRIC CORP ) 1 August 1990**

## Description

The present invention relates to the field of microwave frequency converters.

It is known that to provide a frequency converter a local oscillator and a frequency mixer are both necessary. In the case of microwave conversion the local oscillator generates a radiofrequency carrier designed to convert an intermediate frequency signal. The mixer operates nonlinearly on the local frequency and on the intermediate frequency signals producing a complex signal comprising the above local frequency, two side bands corresponding to two frequency translations of the intermediate frequency signal band, and the products of a higher order of intermodulation.

Microwave oscillators are embodied with active elements, for example with gallium arsenide field effect transistors (GaAs FET), and generally include resonant cavities.

The mixers can be embodied either with active elements, generally transistors, or with passive elements, e.g. diodes. In both cases the nonlinearity of the components is utilized.

The possibility of utilizing the nonlinearity of the active device included in the local oscillator to obtain, with a single device, both generation of the local frequency and frequency conversion of an intermediate frequency signal, appropriately coupled with said active device, is also known.

Said converters have the advantage of reducing the complexity of the circuitry compared with converters in which oscillator and mixer are embodied separately, compared with the latter they have however some drawbacks.

A first drawback is due to the fact that the frequency stability of the local oscillator depends on the presence and level of the intermediate frequency signal, mainly because of the noise introduced in the local frequency phase.

A second drawback is due to the fact that the power gain obtained in the conversion operation is not easy to control because it depends on the calibration of the local frequency.

A third drawback is due to the fact that in the output signal there can be intermodulation products of the third order dependent on the local intermediate frequency calibration procedure; in addition the noise figure of the device also depends on said calibrations.

Because of the above drawbacks, the advantages of self-oscillating converters of known type are not such as to make them still preferable to conventional converters. However most of the cited drawbacks can be avoided only by including dielectric resonators into self-oscillating converters.

The German patent application DE-A-2816586 discloses a "Self-oscillating mixer circuit" adapted for converting a radio frequency signal of SHF-band into an intermediate frequency signal. Said circuit comprises: a) a single-gate FET having a control terminal, a common terminal and an output terminal; b) a positive feedback path provided between the output terminal and the control terminal of said FET; c) a first microstrip line connected to the control terminal of the FET and adapted to feed said radiofrequency signal thereto; d) a dielectric resonator, having a resonant frequency coincident with the desired self-oscillation frequency, electromagnetically coupled to said first microstrip line; e) a low-pass filter constituted by a second microstrip line connected to the output terminal of said FET where the intermediate frequency signal is produced.

The above mentioned self-oscillating mixer circuit is particularly efficient in down-conversion. In up-conversion its power gain is very poor because the intermediate frequency signal should be introduced at the output terminal of the FET, where the FET has no power gain.

Accordingly the purpose of the present invention is to obviate said drawbacks and indicate a self-oscillating microwave frequency converter adapted for converting an intermediate frequency signal into a radiofrequency signal.

To achieve said purposes the object of the present invention is a self-oscillating microwave frequency converter as described in claim 1, with further reference to two possible embodiment variants described in claims 5 and 6 respectively.

The converter which is the object of the present invention, compared with conventional converters, has the advantages due to less complex circuitry and the fact that it requires no added amplifiers for the intermediate frequency signals and radiofrequency signals.

Compared with known self-oscillating converters, the converter which is the object of the present invention generates a stabler local frequency which no longer depends on the presence of the intermediate frequency signal. This brings an advantage due to the simplification introduced in the testing of the converter, which is limited to calibration of only the local frequency.

A second advantage is due to the power gain stability obtained in the conversion of the intermediate frequency signal; indeed said gain is no longer dependent on the calibration of the local frequency.

Other advantages are due to the low level of the intermodulation products generated, low value of the noise figure, and less power consumption.

Further purposes and advantages of the present invention will be clarified by the following detailed description of an example of embodiment thereof and the annexed drawings given by way of nonlimiting example and in which:

FIG. 1 shows a block diagram of a microwave oscillator circuit of known type from which are drawn the theoretical considerations useful in the description of the invention;

FIG. 2 shows the circuitry of the self-oscillating converter which is the object of the present invention.

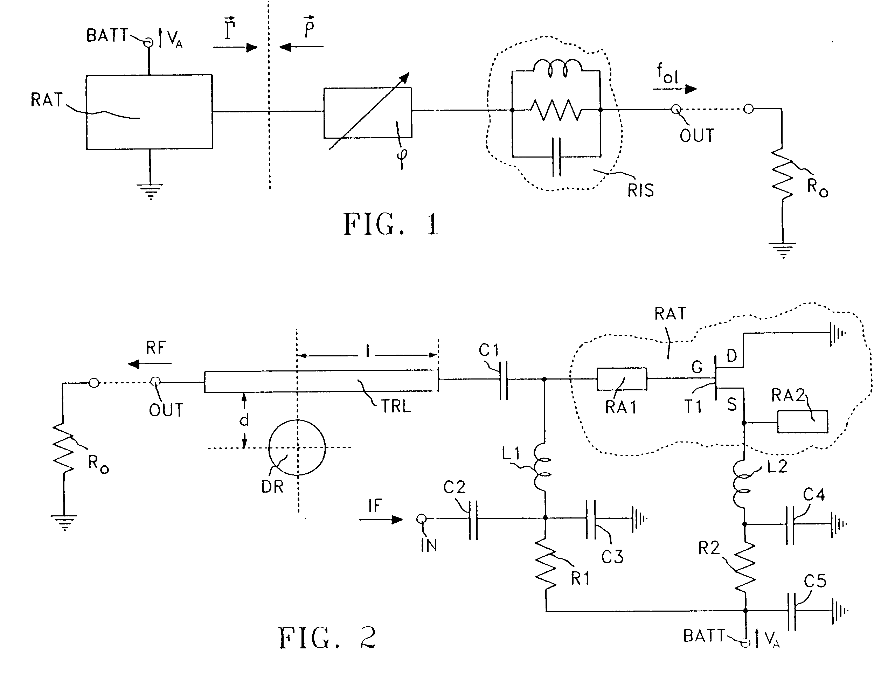

With reference to FIG. 1, RAT indicates an active network connected to a supply gate BATT to which arrives a positive voltage $V_A$. The network RAT is connected to a variable phase shifter $\phi$ in turn connected to an end of a resonant circuit RIS having the other end connected to an output gate OUT. The resonant circuit RIS has a resonance frequency $f_{ol}$ belonging to the microwave field.

A load circuit having an impedance $R_o$, such as to constitute a matched load, is connected between the output gate OUT and ground.

The circuit of FIG. 1, in accordance with the diffusion matrix theory, behaves like an oscillator generating at the gate OUT a sinusoidal oscillation at frequency $f_{ol}$ if the following vectorial condition is verified:

$$\vec{\Gamma} \times \vec{\rho} = 1$$

where $\vec{\rho}$ is a vector which represents the reflection coefficient of the active network RAT and $\vec{\Gamma}$ is a vector which represents the reflection coefficient of the circuit consisting of the variable phase shifter $\phi$ connected to the resonant circuit RIS closed on the matched load $R_o$.

The vectorial condition is equivalent to the following two conditions:

$$|\vec{\Gamma}| \times |\vec{\rho}| = 1 \ e \ \angle\vec{\Gamma} = -[\angle\vec{\rho} + 2k\pi]$$

where $k = 0, 1, 2, \ldots$

It is possible to act on the variable phase shifter $\phi$ to obtain, not considering the sign, phase equality expressed by the condition on the phases, when it is not already verified initially.

No input is provided for the oscillator of FIG. 1 because, as it is known, the thermal noise always present in the devices employed is sufficient to fire a sinusoidal oscillator in the circuit. The level of said oscillation, once fired, would tend to increase indefinitely, except that beyond a certain limit the gain of the active network RAT no longer increases linearly with the oscillation level generated. Consequently further increases in level beyond said limit let the network RAT work in a gain compression zone which has the effect of automatically stabilizing the condition of the modules of $\vec{\Gamma}$ and $\vec{\rho}$. Unfortunately said nonlinearity unavoidably involves the generation of undesired products of intermodulation of a higher order.

With reference to FIG. 2 in which the same elements of FIG. 1 are indicated by the same symbols, there is noted a gallium arsenide field effect transistor T1 having the drain electrode D connected to ground.

A positive voltage $V_A$ reaches a supply gate BATT of the self-oscillating converter shown in the figure. To the gate BATT are connected two polarization networks of the transistor T1. A first of said networks polarizes the gate electrode G of T1; it consists of the connection of a resistance R1 in series with an inductance L1 and with a first impedance matching network RA1 for a radiofrequency signal RF generated by the converter. A second polarization network polarizes the source electrode S of T1; it comprises a resistance R2 connected in series to an inductance L2. The resistances R1 and R2 are connected to the gate BATT; a capacitor C5 is placed between said gate and ground to filter supply disturbance.

One end of the matching network RA1 is connected to the gate electrode of T1, the other end is connected to the inductance L1 and to an end of a capacitor C1 whose other end is connected to a first end of a transmission line TRL.

One end of a second impedance matching network RA2 for the above radiofrequency signal RF is connected to the source electrode S of T1 and to the inductance L2, while the other end is open.

The central point of the series connection of R2 and L2 is connected to one end of a capacitor C4 which has its other end grounded.

The resistance R1 and the inductance L1 are also connected to first ends of a capacitor C2 and a capacitor C3. The second end of the capacitor C3 is connected to ground; the second end of the capacitor C2 is connected to a gate IN to which arrives an intermediate frequency signal IF.

A second end of the transmission line TRL is connected to a gate OUT from which emerges the radiofrequency signal RF generated by the converter. Said signal is made to reach a load circuit represented by a resistance $R_o$, which constitutes a matched load, connected between the gate OUT and ground.

The two impedance matching networks RA1 and RA2 and the transmission line TRL consist of sections of microstrip line appropriately dimensioned and having a characteristic impedance of 50 Ohm.

A dielectric resonator DR with circular shape is placed beside the line TRL: the center of the resonator is placed at a distance $\underline{d}$ from the line TRL, and at a corresponding distance $\underline{1}$, on the same line, from the first end of the line; the distance $\underline{d}$ is such that it allows appropriate electromagnetic coupling between the line TRL and the dielectric resonator DR.

The dielectric resonator DR is of known type consisting of a disc of ceramic material having a radius and thickness such as to produce an electromagnetic resonance with self-oscillating frequency $f_{o1}$ (FIG. 1).

The operation of the self-oscillating microwave converter of FIG. 2 takes place on the basis of the same theoretical considerations made for the microwave oscillator of FIG. 1. Compared with the latter, there are added parts which allow coupling the intermediate frequency signal IF to the transistor T1, preventing the radiofrequency signal RF generated by said converter from reaching the gates IN and BATT. Introduction of the signal IF causes generation of a radiofrequency signal different from the simple sinusoidal oscillation $f_{o1}$ generated by the circuit of FIG. 1. Indeed, due to the effect of the nonlinearity of the gain characteristic of T1, the radiofrequency signals comprises, in addition to the said oscillation $f_{o1}$, two side bands corresponding to frequency translations of the signal band IF plus some intermodulation products of a higher order, in particular those of odd order.

In the circuit of FIG. 2 the network consisting of the transistor T1 with the respective matching networks RA1 and RA2 corresponds to the active network RAT of the theoretical circuit of FIG. 1. Similarly, the dielectric resonator DR corresponds to the resonant circuit RIS (FIG. 1). The transmission line TRL corresponds to the variable shifter φ. The optimum phase of the reflection coefficient $\vec{\Gamma}$, able to cause firing of the oscillation $f_{o1}$, is set during the testing of each converter reduced; the optimum phase corresponds to an optimum length of the distance l.

The intermediate frequency signal IF reaches the gate electrode G of the transistor T1 through the capacitor C2, the inductance L1 and the impedance matching network RA1. For this purpose the values of C2 and L1 are such as to make these components short circuits for said signal. The values of C1 and C3 make said capacitors open circuits for said signal, preventing respectively the signal IF from reaching the line TRL and being short circuited to ground. The values of L2 and C4 are such as to make these components short circuits for the signal IF; thereby the signal IF is present only on the gate electrode G of T1.

The radiofrequency signal generated in the circuit is present on the gate electrode G and source electrode S of the transistor T1. A first low-pass filter consisting of L1 and C3 prevents the radiofrequency signal present in G from reaching the gates IN and BATT. A second low-pass filter, consisting of L2 and C4 prevents the radiofrequency signal present in S from reaching the gate BATT. For this purpose the values of L1 and L2 are such as to make these components open circuits for the radiofrequency signal, while the values of C3 and C4 make said capacitors short circuits for said signal.

The capacitor C1 behaves like a short circuit for the radiofrequency signal and allows it to run through the transmission line TRL and reach the output gate OUT.

The dielectric resonator DR and the transmission line TRL constitute a very selective band-rejection filter. More precisely, in a very small neighbourhood of the resonance frequency $f_{o1}$ said filter reflects approximately half of the power of the signal RF to the gate electrode G of T1; this involves a value of |$\vec{\Gamma}$| which satisfies the above mentioned firing conditions of the self-oscillating converter. Outside said frequency neighbourhood the filter behaves like a simple transmission line which lets pass without attenuation the signal IF converted to radiofrequency.

The circuit of FIG. 2 obtains a frequency conversion with a high power level because the signal IF is injected directly at a point where the radiofrequency power available is maximal. This point coincides with the gate electrode G of T1. The fact that all the available power supplied by T1 emerges from the gate electrode is attributed to the reactive parasite elements in the transistor 1. Said elements, although they have very small values, have sufficiently low impedances at high frequencies of the signal RF.

Obtaining a frequency conversion with a high power level involves a very linear operation of the converter. Indeed, the intermodulation products of the third and fifth orders, which are the only ones included in the useful band of operation of the converter, have very low power levels.

A band pass filter between the gate OUT and the load Ro, not shown in the figures, having a center band frequency corresponding to $f_{o1}$+IF or $f_{o1}$-IF and an appropriate band width, allows taking the upper or lower side band respectively of the signal IF converted to radiofrequency.

The self-oscillating converter of FIG. 2 is embodied on an allumina substrate and generates a local frequency $f_{o1}$ of 10GHz. The intermediate frequency signal IF which reaches the gate IN is 70MHz; therefore the band of the radiofrequency signal RF is between 9.93GHz and 10.07GHz.

The power of the frequency $f_{o1}$ alone generated at the output at the gate OUT is approximately 10dBm (10mW). The gain $P_{RF}/P_{IF}$ is approximately 10dB; said gain corresponds to the ratio of the radiofrequency signal power included in a single side band and the power of the signal IF. The noise figure is greater than 5dB.

To justify the above assertions concerning the good linearity of operation of the converter which is the object of the present invention, the following numeric example concerning the power of the intermodulation products of the third order generated by said converter provides clarification. Supposing that the signal IF at the gate IN consists of two tones spaced 10MHz apart and having a power of -20dBm, there is obtained at the output OUT a signal RF in which each side band comprises said tones of the signal IF transposed to radiofrequency with a power of -10dBm per tone, plus two tones corresponding to the intermodulation products of the third order having a power level of -58dBm per tone.

A variant of the self-oscillating converter described in FIG. 2 consists of replacing the gallium arsenide field effect transistor T1 with a bipolar junction transistor operating at microwaves. In the case of said variant, the circuit remains the same as that of the example of FIG. 2, the values of the components remain identical, and all the considerations concerning the operation and advantages of the converter remain identical.

**Claims**

1. Self-oscillating frequency converter comprising: an amplification device (T1) operating at microwaves with a nonlinear gain characteristic having at least a first gain control electrode (G); a transmission line (TRL) having a first end connected to said control electrode (G); a dielectric resonator (DR) electromagnetically coupled to said transmission line (TRL) and having resonance frequency $(f_{o1})$ in the microwave range, said resonance frequency $(f_{o1})$ being the self-oscillating frequency of the converter, **characterized in that**:

- a second end of said transmission line (TRL) is connected to a radiofrequency output port (OUT) of said converter;
- the first end of said transmission line (TRL) is coupled to said first electrode (G) through first coupling means (C1,RA1) which allow to a radiofrequency signal (RF) emerging from said first electrode (G) to reach said output port (OUT), and preventing said intermediate frequency signal (IF) from reaching said output port (OUT);
- second coupling means (C2,L1,C3) are provided tor coupling the input intermediate frequency signal (IF) to said first electrode (G), and preventing said radio frequency signal (RF) from reaching an input port (IN) to which arrives said input intermediate frequency signal (IF);

   **and in that** said amplification device (T1) converts said intermediate frequency signal (IF) to radiofrequency with power gain, and thereby obtaining said radiofrequency signal (RF) consisting of a sinusoidal oscillation at the resonance frequency $(f_{o1})$ and side bands corresponding to frequency translations with power amplification of the band of said intermediate frequency signal (IF).

2. Self-oscillating frequency converter in accordance with claim 1, characterized in that said first coupling means (C1,RA1) consist of:

- a capacitor (C1) of appropriate value having a first end connected to said first end of said transmission line (TRL) and a second end connected to said second coupling means (L1);
- a first impedance matching network (RA1), acting at radiofrequency, having a first end connected to said first electrode (G) of said amplification device (T1) and a second end connected to the second end of said capacitor (C1).

3. Self-oscillating frequency converter in accordance with claim 1, characterized in that said second coupling means comprise a first filtering network (C2,L1,C3) of the low-pass type connected to said input port (IN), to said first coupling means (C1,RA1), and to a power supply port (BATT), the second coupling means also preventing said radiofrequency signal (RF) from reaching said supply port (BATT).

4. Self-oscillating frequency converter in accordance with claim 1 or 3, characterized in that it further comprises:

- a second filtering network (L2,C4) of the low-pass type placed between a second electrode (S) of said amplification device (T1) and said power supply port (BATT) to prevent said radiofrequency signal (RF) from reaching said supply port (BATT);
- a second impedance matching network (RA2), acting at radiofrequency, connected to said second electrode (S), a third electrode (D) of said amplification device (T1) being grounded.

5. Self-oscillating frequency converter in accordance with claim 1, characterized in that said amplification device (T1) operating at microwaves is a field effect transistor, that said first electrode (G) to which arrives said intermediate frequency signal (IF) coincides with the gate electrode of said transistor, and that second and third electrodes (S,D) coincide with the source and drain electrodes respectively of said transistor.

6. Self-oscillating frequency converter in accordance with claim 1, characterized in that said amplification device (T1) operating at microwaves is a bipolar junction transistor, that said first electrode (G) to which arrives said intermediate frequency signal (IF) coincides with the base electrode of said transistor and that second and third electrodes (S,D) coincide with the emitter and collector electrodes respectively of said transistor.

7. Self-oscillating frequency converter in accordance with claim 1 or 2 or 3, characterized in that said transmission line (TRL) and said impedance matching networks (RA1,RA2) are in microstrip.

**Patentansprüche**

1. Eigenschwingungsfrequenzwandler, bestehend aus: einem im Mikrowellenbereich arbeitenden Verstärkungselement (T1) mit nichtlinearen Verstärkungseigenschaften und wenigstens einer ersten Elektrode zur Verstärkungssteuerung (G); einer Übertragungsleitung (TRL), deren erster Endpunkt an besagte Steuerelektrode (G) angeschlossen ist; einem dielektrischen Resonator (DR), der an besagte Übertragungsleitung (TRL) elektromagnetisch gekoppelt ist und eine Resonanzfrequenz $(f_{o1})$ im Mikrowellenbereich hat. Diese Resonanzfre-

quenz ($f_{o1}$), die die Eigenschwingungsfrequenz des Frequenzwandlers ist, zeichnet sich durch folgende Eigenschaften aus:

- ein zweiter Endpunkt der besagten Übertragungsleitung (TRL) ist an ein Hochfrequenzausgangs-Gate (OUT) des besagten Frequenzwandlers angeschlossen;
- der erste Endpunkt der besagten Übertragungsleitung (TRL) ist an besagte erste Elektrode (G) mittels erster Kopplungselemente (C1, RA1) angeschlossen, welche ermöglichen, daß ein von besagter erster Elektrode (G) ausgehendes Hochfrequenzsignal (RF) an besagtes Hochfrequenzausgangs-Gate (OUT) übertragen werden kann, wobei verhindert wird, daß das besagte Zwischenfrequenzsignal (IF) an das besagte Ausgangs-Gate (OFT) übertragen wird;
- zweiten Kopplungselementen (C2, L1, C3) zur Kopplung des eingehenden Zwischenfrequenzsignals (IF) an besagte erste Elektrode (G) und zur Verhinderung, daß das besagte Hochfrequenzsignal (RF) an das Eingangs-Gate (IN) übertragen wird, an welchem das besagte Zwischenfrequenzsignal (IF) ankommt;

Eine weitere Charakteristik besteht darin, daß das besagte Verstärkungselement (T1) das besagte Zwischenfrequenzsignal (IF) in eine Hochfrequenz mit Leistungsverstärkung umwandelt, so daß das Hochfrequenzsignal (RF) aus einer Sinuswellenschwingung mit einer Resonanzfrequenz $f_{o1}$ sowie aus Seitenbändern besteht, die den Frequenzverschiebungen mit Leistungsverstärkung des Bandes des besagten Zwischenfrequenzsignals (IF) entspricht.

2. Eigenschwingungsfrequenzwandler, wie unter Inanspruchnahme 1) beschrieben, jedoch gekennzeichnet dadurch, daß die besagten ersten Kopplungselemente (C1, RA1) aus folgenden Komponenten bestehen:

- ein Kondensator (C1) mit angemessenem Wert, dessen erster Endpunkt an den ersten Endpunkt der besagten Übertragungsleitung (TRL) angeschlossen ist und dessen zweiter Endpunkt an die besagten zweiten Kopplungselemente (L1) angeschlossen ist;
- ein erstes Netz zur Impedanzangleichung (RA1), das im Hochfrequenzbereich arbeitet und dessen erster Endpunkt an die besagte erste Elektrode (G) des besagten Verstärkungselementes (T1) angeschlossen ist und dessen zweiter Endpunkt an den zweiten Endpunkt des besagten Kondensators (C1) angeschlossen ist.

3. Eigenschwingungsfrequenzwandler, wie unter Inanspruchnahme 1) beschrieben, jedoch gekennzeichnet dadurch, daß zu den besagten zweiten Kopplungselementen ein erstes, aus Tiefpaßfiltern bestehendes Netz (C2, L1, C3) gehört, das an das besagte Eingangs-Gate (IN), an die besagten ersten Kopplungselemente (C1, RA1) sowie an das besagte Leistungsversorgungs-Gate (BATT) angeschlossen ist, wobei die besagten zweiten Kopplungselemente verhindern, daß das besagte Hochfrequenzsignal (RF) an das besagte Leistungsversorgungs-Gate (BATT) übertragen wird.

4. Eigenschwingungsfrequenzwandler, wie unter Inanspruchnahme 1) oder auch 3) beschrieben, jedoch gekennzeichnet dadurch, daß folgende weiteren Komponenten vorhanden sind:

- ein zweites, aus Tiefpaßfiltern bestehendes Netz (L2, C4), das zwischen einer zweiten Elektrode (S) des besagter Verstärkungselementes (T1) und dem Leistungsversorgungs-Gate (BATT) installiert ist und verhindert, daß das besagte Hochfrequenzsignal (RF) an das besagte Leistungsversorgungs-Gate (BATT) übertragen wird.
- ein zweites Netz zur Impedanzanpassung (RA2), das im Hochfrequenzbereich arbeitet und an die besagte zweite Elektrode (S) sowie an eine dritte, geerdete Elektrode (D) des besagten Verstärkungselementes (T1) angeschlossen ist.

5. Eigenschwingungsfrequenzwandler, wie unter Inanspruchnahme 1) beschrieben, jedoch gekennzeichnet dadurch, daß es sich bei besagtem Verstärkungselement (T1) um einen im Mikrowellenbereich arbeitenden Feldtransistor handelt und daß die erste Elektrode (G), an der das besagte Zwischenfrequenzsignal (IF) ankommt, mit dem Elektroden-Gate des besagten Transistors identisch ist und daß die zweite und dritte Elektrode (S, D) mit der Source- bzw. Drain-Elektrode des besagten Transistors identisch sind.

6. Eigenschwingungsfrequenzwandler, wie unter Inanspruchnahme 1) beschrieben, jedoch gekennzeichnet dadurch, daß es sich bei besagtem Verstärkungselement (T1) um einen im Mikrowellenbereich arbeitenden zweipoligen Flächentransistor handelt und daß die erste Elektrode (G), an der das besagte Zwischenfrequenzsignal (IF) ankommt, mit der Basis-Elektrode des besagten Transistors identisch ist und daß die zweite und dritte Elektrode (S, D) mit der Steuer- bzw. Sammelelektrode des besagten Transistors identisch sind.

7. Eigenschwingungsfrequenzwandler, wie unter Inanspruchnahme 1) bzw. 2) bzw. 3) beschrieben, jedoch gekennzeichnet dadurch, daß die besagte Übertragungsleitung (TRL) sowie die besagten Netze zur Impedanzanpassung (RA1, RA2) als Mikrostreifenleiter ausgeführt sind.

## Revendications

1. Convertisseur de fréquence auto-oscillant comprenant: un dispositif d'amplification (T1) fonctionnant aux micro-ondes avec une caractéristique de gain non-linéaire, ayant au moins une première électrode de contrôle de gain (G); une ligne de transmission (TRL) ayant une première extrémité connectée à ladite électrode de contrôle (G); un résonateur diélectrique (DR) accouplé électromagnétiquement à ladite ligne de transmission (TRL) et ayant une fréquence de résonance ($fo_1$) dans la gamme des micro-ondes, cette fréquence de résonance ($fo_1$) étant la fréquence auto-oscillante du convertisseur, caractérisé par le fait que:

   . une seconde extrémité de ladite ligne de transmission (TRL) est connectée à une porte de sortie à fréquence radio (OUT) dudit convertisseur;
   . la première extrémité de ladite ligne de transmission (TRL) est accouplée à ladite première électrode (G) à travers de premiers moyens d'accouplement (C1, RA1) qui permettent au signal à fréquence radio (RF) d'émerger de ladite première électrode (G) pour arriver à ladite porte de sortie (OUT), et éviter que ledit signal à fréquence intermédiaire (IF) puisse arriver à ladite porte de sortie (OUT);
   . de seconds moyens d'accouplement (C2, L1, C3) sont pourvus pour l'accouplement du signal d'entrée à fréquence intermédiare (IF) à ladite première électrode (G), et éviter que ledit signal à fréquence radio (RF) puisse arriver à une porte d'entrée (IN) à laquelle arrive ledit signal d'entrée à fréquence intermédiaire (IF);

   et par le fait que ledit dispositif d'amplification (T1) convertit ledit signal à fréquence intermédiare (IF) en fréquence radio avec gain de puissance, obtenant ainsi ledit signal à fréquence radio (RF) consistant en une oscillation sinusoïdale à la fréquence de résonance ($fo_1$) et bandes latérales correspondant à des translations de fréquence avec amplification de puissance de la bande dudit signal à fréquence intermédiaire (IF).

2. Convertisseur de fréquence auto-oscillant, conformément à la Revendication 1, caractérisé par le fait que lesdits premiers moyens d'accouplement (C1, RA1) sont constitués de:

   . un condensateur (C1) d'une valeur convenable, ayant une première extrémité connectée à ladite première extrémité de ladite ligne de transmission (TRL) et une seconde extrémité connectée auxdits seconds moyens d'accouplement (L1);
   . un premier réseau d'adaptation d'impédance (RA1), agissant à fréquence radio, ayant une première extrémité connectée à ladite première électrode (G) dudit dispositif d'amplification (T1) et une seconde extrémité connectée à la seconde extrémité dudit condensateur (C1).

3. Convertisseur de fréquence auto-oscillant, conformément à la Revendication 1, caractérisé par le fait que lesdits seconds moyens d'accouplement incluent un premier réseau filtrant (C2, L1, C3) du type passe-bas connecté à ladite porte d'entrée (IN), auxdits premiers moyens d'accouplement (C1, RA1), et à une porte d'alimentation d'énergie (BATT), et les seconds moyens d'accouplement évitent également que ledit signal de fréquence radio (RF) puisse arriver à ladite porte d'alimentation (BATT).

4. Convertisseur de fréquence auto-oscillant, conformément à la revendication 1 ou 3, caractérisé par il fait qu'il inclut en plus:

   - un second réseau filtrant (L2, C4) du type passe-bas, situé entre une seconde électrode (S) dudit dispositif d'énergie (BATT) pour éviter que ledit signal de fréquence radio (FR) arrive à ladite porte d'alimentation (BATT);
   - un second réseau d'adaptation d'impédance (RA2), agissant à fréquence radio, connecté à ladite deuxième électrode (S), une troisième électrode (D) dudit dispositif d'amplification étant mise à la terre.

5. Convertisseur de fréquence auto-oscillant conformément à la Revendication 1, caractérisé par le fait que ledit dispositif d'amplification (T1) fonctionnant aux micro-ondes est un transistor à effet de champ, que ladite première électrode (G) à laquelle arrive ledit signal de fréquence intermédiaire (IF) coïncide avec l'électrode de porte dudit transistor, et que la deuxième et troisième électrode (S, D) coïncident respectivement avec les électrodes de source et drain dudit transistor.

6. Convertisseur de fréquence auto-oscillant conformément à la Revendication 1, caractérisé par le fait que ledit dispositif d'amplification (T1) fonctionnant aux micro-ondes est un transistor à jonction bipolaire, que ladite première électrode (G) à laquelle arrive ledit signal de fréquence intermédiaire (IF) coïncide avec l'électrode de base dudit transistor et que la deuxième et troisième électrode (S, D) coïncident respectivement avec les électrodes d'émetteur et collecteur dudit transistor.

7.  Convertisseur de fréquence auto-oscillant conformément aux Revendications 1 ou 2 ou 3, caractérisé par le fait que ladite ligne de transmission (TRL) et lesdits réseaux d'adaptation d'impédance (RA1, RA2) sont réalisés en microbande.

FIG. 1

FIG. 2